# EUROPEAN PATENT SPECIFICATION

(11) **EP 2 066 035 B1**
(45) Date of publication and mention of the grant of the patent: **12.09.2012**
(21) Application number: 07830943.2
(22) Date of filing: 31.10.2007
(51) Int. Cl.: H03L 7/14, H03L 7/093, H03L 7/095

(54) **OSCILLATION FREQUENCY CONTROL CIRCUIT**
SCHWINGUNGSFREQUENZSTEUERKREIS
CIRCUIT DE COMMANDE DE FRÉQUENCE D'OSCILLATION

(30) Priority: 26.12.2006 JP 2006349519
(43) Date of publication of application: 03.06.2009
(73) Proprietor: Nihon Dempa Kogyo Co., Ltd., Shibuya-ku Tokyo 151-8569 (JP)
(72) Inventor: ONISHI, Naoki, Chitose-shi Hokkaido 066-0009 (JP)
(74) Representative: Liesegang, Eva
(86) International application number: PCT/JP2007/071209
(87) International publication number: WO 2008/078452

(56) References cited:
- JP-A- 01 222 519
- JP-A- 04 369 927
- JP-A- 2006 121 171
- JP-U- 04 050 935
- US-A- 5 335 364
- US-B1- 6 313 708
- US-B1- 7 015 762

## Description

### Technical Field

The present invention relates to an oscillation frequency control circuit according to the preamble of claim 1 and 2, and more particularly, to an oscillation frequency control circuit capable of correcting its own frequency in synchronism with an output signal and maintaining a stable oscillation frequency even when a highly stable reference signal is not input thereto.
An oscillation frequency control circuit according to the preamble of claims 1 and 2 is disclosed in US 6,313,708 B1.
A reference timing signal apparatus including an oscillator with phase-locked loop which provides a clock signal in a CDMA base station, is disclosed in US 7,015,762 B1.
US 5,335,364 A describes a circuit arrangement by which a voltage-controlled temperature-compensated oscillator serving as the frequency reference in a radio telephone is controlled.

### Background Art

In a base station of a next-generation mobile communication system, a terrestrial digital broadcasting system, and the like, the precision required for a frequency reference signal has become higher.
In order to generate a frequency reference signal, a cesium frequency reference oscillator, a rubidium frequency reference oscillator, a reference oscillator of a frequency synchronization type using a GPS signal, and the liker are used in broadcasting and communication systems.

However, since these oscillators are usually expensive, the reference signal from the oscillators is divided to be used as a reference signal source of an apparatus.

The divided reference signal is used as a reference clock for a communication system.
Specifically, the reference signal is used as a reference signal for phase comparison in a PLL (phase locked loop) circuit, a reference clock signal for a DSP (digital signal processor), an FPGA (field programmable gate array) or the like, and a sampling clock for a D/A (digital/analog) converter or an A/D (analog/digital) converter.

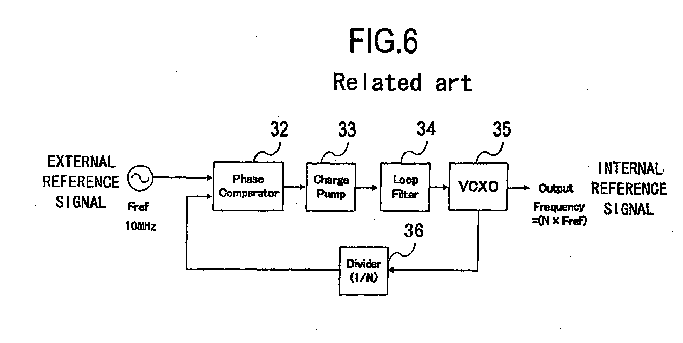

### [Conventional PLL Circuit: Fig. 6]

Next, a description of a conventional PLL circuit will be provided with reference to Fig. 6. Fig. 6 is a configuration block diagram of a typical PLL circuit.
As illustrated in Fig. 6, the PLL circuit is provided with a phase comparator 32 configured to compare an external reference signal (Fref) with a 1/N divided signal to output a phase difference signal, a charge pump 33 configured to output the phase difference as a pulse width signal, a loop filter 34 configured to smooth out an output voltage from the charge pump 33, a voltage controlled crystal oscillator (VCXO) 35 configured to change a frequency in accordance with a control voltage from the loop filter 34 to oscillate and output a desired frequency (internal reference signal: output frequency), and a frequency divider (divider) 36 configured to divide the output (internal reference signal) of the VCXO 35 to 1/N.
The internal reference signal corresponds to an N*Fref signal.

The PLL circuit is configured to apply feedback control to the internal VCXO 35 so that a phase difference between an external reference signal and the output frequency of the VCXO 35 to thereby obtain an oscillator output synchronized with the reference signal.

Specifically, the phase comparator 32 is configured to compare phases of a highly stable external reference signal and an output signal from the VCXO 35 performing frequency control based on an input voltage and perform PLL control so that a DC voltage obtained by smoothing out a phase comparison result is fed back to the VCXO 35 to thereby generating a highly precise signal.
The PLL circuit is widely used in communication and broadcasting apparatuses and the like.

An example of the prior art of an oscillation frequency control circuit in the conventional oscillator is disclosed in Japanese Patent Application Laid-Open No. 2000-083003 (Patent Document 1) and Japanese Patent Application Laid-Open No. 2003-179489 (Patent Document 2).

Patent Document 1 discloses a free running frequency adjustment system in which a frequency counter performs a counting operation synchronized with an output signal of a VCO (voltage controlled oscillator) which is input within a period of time corresponding to a pulse width, a latch circuit stores therein a count value corresponding to an oscillation frequency of the VCO, and when the count value deviates from a predetermined range, a CPU changes an application voltage to the VCO to adjust a free-running frequency of the VCO 10 to be within a predetermined range.

Patent Document 2 discloses a phase locked loop circuit having a function of automatically adjusting a free-running frequency of a voltage-controlled oscillator (VCO), in which a microcomputer counts the number of pulses of a pulse signal output from the VCO in a period in which an output from a phase comparator is at a predetermined level and updates a control data based on the counted value, and a DAC (digital analog converter) converts the data to an analog signal so that the analog signal is combined with a signal from an LPF (low pass filter) to be used as a frequency control signal of the VCO.

Patent Document 1: Japanese Patent Application Laid-Open No. 2000-083003
Patent Document 2: Japanese Patent Application Laid-Open No. 2003-179489

### Disclosure of the Invention

### Problems to be Solved by the Invention

However, in the conventional PLL circuit, since the phase comparison cannot be performed when a reference signal is not input thereto, the PLL circuit may switch over to another external reference signal or operate in a free-running state of the voltage-controlled oscillator. When it switches over to another external reference signal from a backup system, since PLL control is performed again, the deviation of the reference signal depends on the external reference signal, and therefore, it does not cause any problem. However, when it switches over to operate in the free-running state, the frequency is excessively controlled in response to a phase comparison result during the switching to stick to an upper or lower limit frequency, and thus, there is a problem that the frequency deviation becomes large.

As a short-term solution to solve the problem of the free running, a highly stable VC-TCXO (voltage controlled-temperature compensated crystal oscillator) may be used as the voltage-controlled oscillator.
However, although such a solution allows operation with a frequency stability of e.g., ±0.5 ppm, it might not be able to provide satisfactory performance for a long period of time due to aging.

For example, when it is assumed that aging characteristics are about ±1 ppm per year, a frequency deviation may amount to maximum 10.5 ppm at the elapse of 10 years. This may also be explained that if an output frequency of a carrier wave in communication is 800 MHz, a frequency deviation may amount to 8.4 kHz similar to that of the reference frequency. Such a frequency deviation is not allowable to a system.

Moreover, even in a highly stable system using a VC-OCXO (voltage controlled, oven controlled crystal oscillator), since the aging characteristics may cause a frequency deviation in a long period of time, it is necessary to perform a correction operation every predetermined period of time, and therefore, there was a problem that the correction operation is troublesome.

Moreover, the system or circuit disclosed in Patent Document 1 or 2 counts the output of the VCO or the output of the phase comparator to perform adjustment of the free-running frequency. However, the system or circuit does not perform the frequency adjustment by directly detecting an abnormality of the external reference signal and is unable to sufficiently cope with the aging.

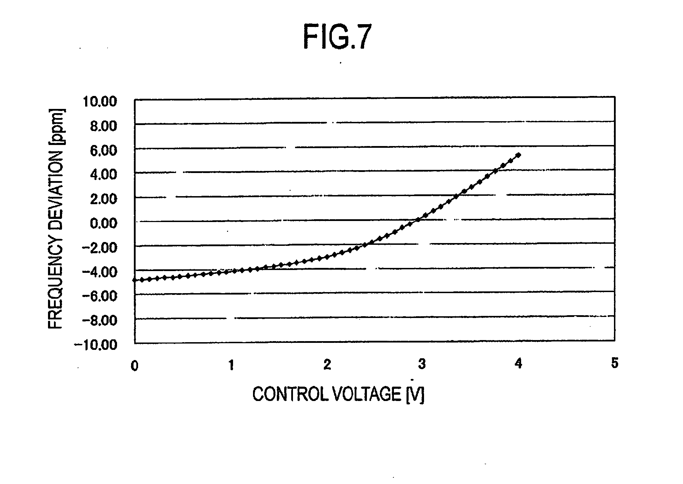

### [Control Voltage Characteristics of VCXO: Fig. 7]

The control voltage characteristics of the VCXO are shown in Fig. 7. Fig. 7 is a view showing exemplary control voltage characteristics of a voltage controlled crystal oscillator. In Fig. 7, the horizontal axis represents a control voltage, and the vertical axis represents a frequency deviation.
In the example VCXO of Fig. 7, the VCXO is able to operate when the control voltage is in the range of 0 to 4 V, while it is unable to operate when the control voltage is 4 V or more.
Since the frequency deviation rises with the lapse of time even in the case of the VCXO, an appropriate control voltage changes accordingly.

The present invention has been made in consideration of the aforementioned situation, and it is an object of the invention to provide an oscillation frequency control circuit capable of correcting its own frequency and maintaining a stable oscillation frequency even when a highly stable reference signal is not input thereto and it operates is in a free-running state.

### Means for Solving the Problems

The present invention provides an oscillation frequency control circuit according to claims 1 and 2. Preferred embodiments are defined in the dependent claims.

To overcome the problems of the conventional techniques, according to an aspect of the present invention, there is provided an oscillation frequency control circuit comprising: a voltage-controlled oscillator; a frequency divider configured to divide an output from the voltage-controlled oscillator; a phase comparator configured to compare phases of an external reference signal and an output from the frequency divider; a loop filter configured to smooth out an output from the phase comparator and output the smoothed output; a detection circuit capable of detecting the external reference signal; a pulse generation circuit configured to generate pulses upon receipt of a pulse generation information to be output to the loop filter; a memory capable of storing therein a prescribed voltage information and the pulse generation information corresponding to the prescribed voltage information; a switch configured to turn on/off a connection between the phase comparator and the loop filter; and a control unit configured to turn on the switch when a level of the external reference signal detected by the detection circuit is within an appropriate range while turning off the switch when the level is outside the appropriate range to thereby output the pulse generation information stored in the memory to the pulse generation circuit.

In the oscillation frequency control circuit according to the first aspect of the present invention, the memory stores an aging characteristics table, the table storing a control voltage appropriate for an aging time and a pulse generation information corresponding to the control voltage, and the control unit measures time by means of a timer provided therein, retrieves the control voltage corresponding to the measured time from the aging characteristics table of the memory when the level of the external reference signal is outside the appropriate range, reads out the pulse generation information corresponding to the retrieved control voltage, and output the read pulse generation information to the pulse generation circuit.

In the oscillation frequency control circuit according to the second aspect of the present invention, a level detection circuit configured to detect a voltage level of an output from the loop filter to thereby output a latest voltage information to the control unit is provided, the memory stores a voltage/pulse generation information table the table storing the latest voltage information, a plurality of voltage information, and a pulse generation information corresponding to the voltage information, and the control unit updates the latest voltage information of the memory to the latest voltage information input from the level detection circuit, reads out the pulse generation information corresponding to the latest voltage information from the voltage/pulse generation information table of the memory when the level of the external reference signal is within the appropriate range, and output the read pulse generation information to the pulse generation circuit.

In the oscillation frequency control circuit according to the above aspect of the present invention, a voltage controlled crystal oscillator, a voltage controlled-temperature compensated crystal oscillator, or a voltage controlled, oven controlled crystal oscillator is used in lieu of the voltage-controlled oscillator.

In the oscillation frequency control circuit according to the above aspect of the present invention, the pulse generation circuit is a pulse width modulation circuit, and the pulse generation information output from the control unit is information on a pulse width modulation duty cycle.

### Advantages of the Invention

According to the above invention, it is possible to provide a stable oscillation frequency which can be maintained by correcting its own frequency even when a highly stable reference signal is not input thereto and it operates in a free-running state. It is further possible to provide frequency correction that can cope with aging.

It is further possible that a stable oscillation frequency can be maintained by succeeding the previous operation state even when the reference signal is not input and it operates in a free-running state.

### Brief Description of the Drawings

Fig. 1 is a configuration block diagram of an oscillation frequency control circuit according to an embodiment of the present invention.
Fig. 2 is a schematic view of a voltage and PWM duty cycle table.
Fig. 3 is a view showing characteristics during correction.
Fig. 4 is a view showing aging and control voltage characteristics.
Fig. 5 is a schematic view of an aging characteristics table.
Fig. 6 is a configuration block diagram of a typical PLL circuit.
Fig. 7 is a view showing exemplary control voltage characteristics of a voltage controlled crystal oscillator.

### Description of Reference Numbers

11: FILTER
12: PHASE COMPARATOR
13: SWITCH
14: LOOP FILTER
15: VOLTAGE-CONTROLLED OSCILLATOR
16: FREQUENCY DIVIDER
17: DETECTION CIRCUIT
18: AMPLIFIER
20: CPU
21: MEMORY
22: PWM CIRCUIT
23: LEVEL DETECTION CIRCUIT
24: AD CONVERTER
25: AD CONVERTER
32: PHASE COMPARATOR
33: CHARGE PUMP
34: LOOP FILTER
35: VCXO
36: FREQUENCY DIVIDER

### Best Mode for Carrying Out the Invention

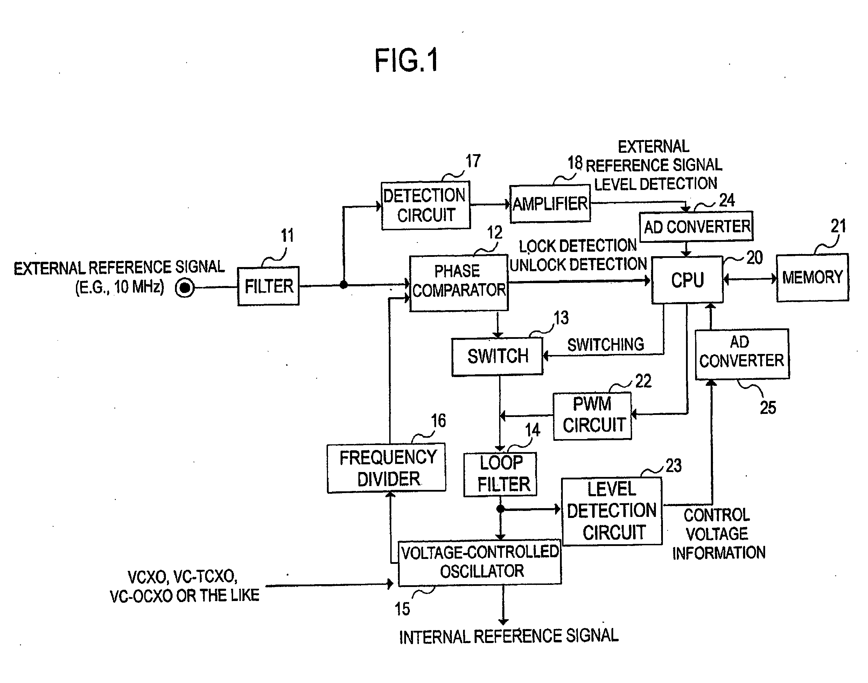

### [Oscillation Frequency Control Circuit: Fig. 1]

A description of an oscillation frequency control circuit according to an embodiment of the present invention will be provided with reference to Fig. 1. Fig. 1 is a configuration block diagram of an oscillation frequency control circuit according to an embodiment of the present invention.
The oscillation frequency control circuit (present circuit) according to the embodiment of the present invention, as shown in Fig. 1, includes a filter 11, a phase comparator 12, a phase comparator 12, a switch 13, a loop filter 14, a voltage-controlled oscillator 15, a frequency divider 16, a detection circuit 17, an amplifier 18, a CPU (central processing unit) 20, a memory 21, a PWM (pulse width modulation) circuit 22, a level detection circuit 23, an AD converter 24, and an AD converter 25.

### [Each Part of Present Circuit]

The filter 11 is a filter configured to limit a band of an external reference signal having a frequency of e.g., 10 MHz. The filter 11 has a function of rejecting a highfrequency component of the external reference signal, although the function is not essential as a basic configuration.
The phase comparator 12 is configured to compare phases of a reference signal output from the filter 11 and a signal of which the frequency is divided by the frequency divider 16 to thereby output a phase difference signal.
Moreover, the phase comparator 12 is configured to compares the phases of the external reference signal and the frequency-divided signal to thereby output a lock detection signal to the CPU 20 when a synchronization (lock) has been detected, while outputting an unlock detection signal to the CPU 20 when an asynchronism (unlock) has been detected.

The switch 13 is configured to turn on/off a connection between the phase comparator 12 and the loop filter 14 in accordance with a switching command from the CPU 20. That is, upon receipt of a turn-on command from the CPU 20, the switch 13 supplies an output from the phase comparator 12 to the loop filter 14, while cutting off the connection between the phase comparator 12 and the loop filter 14 upon receipt of a turn-off command from the CPU 20.

The loop filter 14 is a filter configured to smooth out an output voltage from the phase comparator 12: that is, the filter smoothes out a control voltage to be input to the voltage-controlled oscillator 15.
The voltage-controlled oscillator 15 is configured to change a frequency in accordance with the control voltage from the loop filter 14 to oscillate and output a desired frequency (internal reference signal).
Moreover, a voltage controlled crystal oscillator (VCXO) or a voltage controlled, oven controlled crystal oscillator (VC-OCXO) may be used in lieu of the voltage-controlled oscillator (VCO).

The frequency divider 16 is configured to divide the internal reference signal output from the voltage-controlled oscillator 15 to 1/N.
The detection circuit 17 is configured to detect a level of the output signal from the filter 11.
The amplifier 18 is configured to amplify a signal detected by the detection circuit 17.

The CPU 20 is configured to receive a control voltage information from the AD converter 25 and store the control voltage information in the memory 21 as a latest control voltage information. Specifically, the CPU 20 always receives the control voltage information from the AD converter 25, and when the received control voltage information has not been changed from a previous control voltage information, the control voltage information stored in the memory 21 is not updated, while when the received control voltage information has been changed from the previous control voltage information, the control voltage information of the memory 21 is updated.

Moreover, upon receipt of the detected level of the external reference signal (external REF) from the AD converter 24, the CPU 20 makes a determination as to whether the detected level is within an appropriate range (ranging from a first threshold value to a second threshold value) stored in the memory 21 and output a turn-on command to the switch 13 when it is within the appropriate range while outputting a turn-off command to the switch 13 when it is outside the appropriate range.

Furthermore, when the detection level of the external REF is outside the appropriate range, the CPU 20 refers to a voltage and PWM duty cycle table stored in the memory 21, and outputs a pulse width information corresponding to a PWM duty cycle based on a voltage information of a present (latest) control voltage to the PWM circuit 22.

The memory 21 stores therein the latest control voltage information, the first and second threshold values serving as a basis of the appropriate range for the detection level of the external REF, and the voltage and PWM duty cycle table.
The control voltage information is updated in the memory 21 when a change has been detected by the level detection circuit 23, so that a latest value can be maintained.

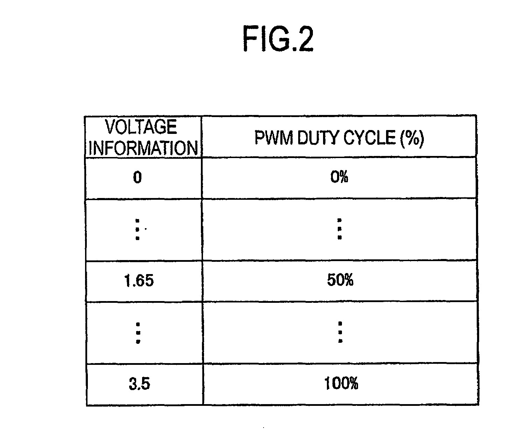

### [Voltage and PWM Duty Cycle Table: Fig. 2]

A description of the voltage and PWM duty cycle table will be provided below with reference to Fig. 2. Fig. 2 is a schematic view of the voltage and PWM duty cycle table.
As shown in Fig. 2, the voltage and PWM duty cycle table stores a PWM duty cycle (%) for specifying a pulse width for a voltage information.

Here, the voltage information is used to predetermine a PWM duty cycle of pulses output from the PWM circuit 22 to the loop filter 14 in order to maintain a value (control voltage information) of the control voltage from the loop filter 14.
Therefore, when a PWM duty cycle corresponding to the control voltage information detected by the level detection circuit 23 is read from the voltage and PWM duty cycle table and the PWM circuit 22 outputs pulses corresponding to the cycle to the loop filter 14, the same control voltage as the previous one is output from the loop filter 14 to the voltage-controlled oscillator 15.

The PWM circuit 22 performs pulse width modulation on data of the PWM duty cycle input from the CPU 20 to thereby output a desired pulse signal to the loop filter 14.

The level detection circuit 23 is configured to detect a DC voltage output from the loop filter 14 to output the detected voltage to the AD converter 25 as the control voltage information.
The AD converter 24 is configured to convert an analog signal of the detection level of the external REF output from the amplifier 18 to a digital signal to be output to the CPU 20.
The AD converter 25 is also configured to convert an analog signal of the control voltage information from the level detection circuit 23 to a digital signal to be output to the CPU 20.

In the present circuit, since the CPU 20 is capable of perceiving an input abnormality of the external reference signal from the detection level of the external REF output from the detection circuit 17 and the amplifier 18, an unlock detection signal from the phase comparator 12 is not used.

### [Operation of Present Circuit]

A description of an operation of the present circuit will be provided.
In a normal operation state of the present circuit, the switch 13 is turned on and the phase comparator 12 and the loop filter 14 are in a connected state. Moreover, the phase comparator 12 outputs the phase difference signal of the external reference signal and the signal from the frequency divider 16 to the voltage-controlled oscillator 15 via the loop filter 14 and controls an oscillation frequency of the voltage-controlled oscillator 15. At this time, the level detection circuit 23 detects a latest control voltage to output the latest control voltage to the CPU 20 via the AD converter 25, and the CPU 20 updates the latest control voltage information stored in the memory 21 when the control voltage information has been changed.

Moreover, in the present circuit, the external reference signal is detected by the detection circuit 17 and amplified by the amplifier 18 so that the level of the external REF is detected and output to the CPU 20 via the AD converter 24.

In the CPU 20, a determination is made as to whether the detection level of the external REF is within the appropriate range. Specifically, the value of the detection level of the external REF is determined to be within the appropriate range when the value is between the first threshold value and the second threshold value representing the appropriate range stored in the memory 21. On the other hand, the value of the detection level of the external REF is determined to be outside the appropriate range when the value is not between the first threshold value and the second threshold value.

When the determination result shows that the detection level is within the appropriate range, the CPU 20 operates in a normal state to maintain the turn-on state of the switch 13. When the determination result shows that the detection level is outside the appropriate range, the CPU 20 operates in an abnormal state to put the switch 13 in a turn-off state so that the connection between the phase comparator 12 and the loop filter 14 is out off.

Furthermore, in the abnormal operation state, the CPU 20 reads out the latest control voltage information stored in the memory 21, reads the PWM duty cycle corresponding to the voltage information from the voltage and PWM duty cycle table, and outputs information (data) for forming pulses corresponding to the PWM duty cycle to the PWM circuit 22.
The PWM circuit 22 generates pulses in accordance with the pulse generation information input from the CPU 20 and output the control voltage to the voltage-controlled oscillator 15 via the loop filter 14.

In this manner, when an abnormality has occurred in the external reference signal, particularly, when the external reference signal is not input thereto (the free-running state), or the like, the CPU 20 immediately detects the abnormality from the output from the detection circuit 17 in the amplifier 18 and cuts off the output of the phase comparator 12, so that the same pulses as the previous control voltage which has been used for controlling the voltage-controlled oscillator 15 can be output from the PWM circuit 22.
That is, by utilizing the output from the PWM circuit 22 in lieu of the output from the phase comparator 12, it is possible to appropriately control the frequency oscillation at the voltage-controlled oscillator 15 by succeeding the previous operation state.

### [Another Embodiment 1]

In the example described above, although the pulses output from the PWM circuit 22 were generated based on the latest control voltage information detected by the level detection circuit 23, a default voltage information may be stored so that the pulse generation information may be output based on the PWM duty cycle corresponding to the default voltage information.

Specifically, the memory 21 stores therein a center voltage value within the appropriate range, of the control voltage of the voltage-controlled oscillator 15. Since the PWM duty cycle corresponding to the center voltage value is 50%, if the control voltage of the voltage-controlled oscillator 14 ranges from 0 to 3.3 V, the center control voltage is set to 3.3/2 V. Moreover, an arbitrary voltage value other than the center voltage value may be stored so that a control voltage is set to a voltage corresponding to the voltage value.
When a default voltage information is used, it is possible to omit components such as the level detection circuit 23 and the AD converter 25 and the voltage and PWM duty cycle table in the memory 21.

### [Correction]

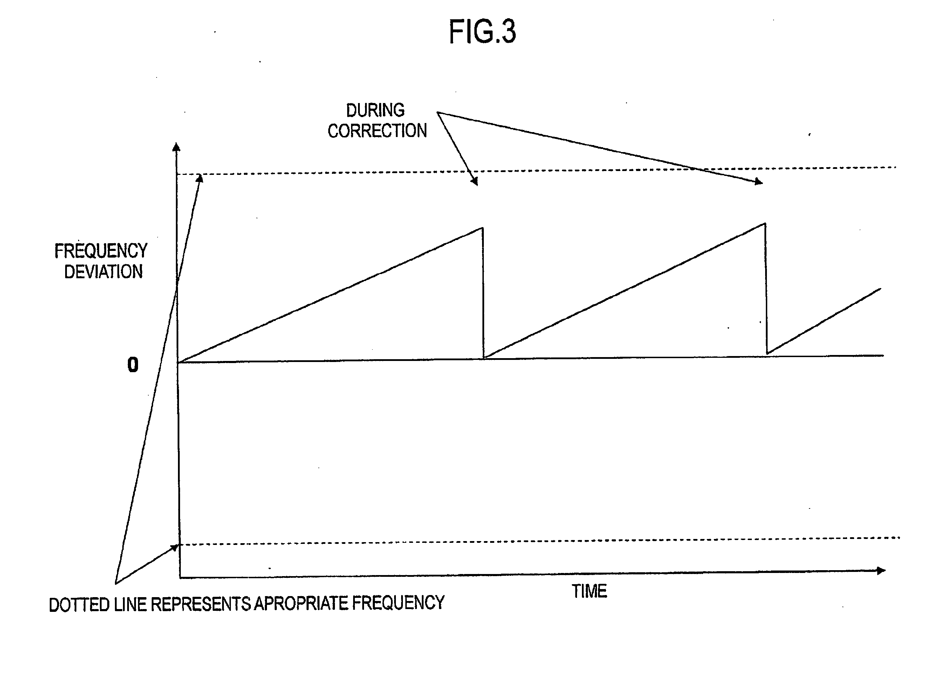

A description of a correction operation of the present circuit will be provided with reference to Fig. 3. Fig. 3 is a view showing characteristics during correction.
In the present circuit, as shown in Fig. 3, when time elapses in a state where the external reference signal is not input thereto, the frequency deviation rises or falls. In the drawing, a case is shown where the frequency deviation is rising. Therefore, an appropriate reference signal is input at a specific timing, and when the inputting of the reference signal is stopped, the correction is made such that the frequency deviation returns to the center frequency by free-running control. Such corrections are repeated twice in Fig. 3.

In this correction, the frequency control is carried out by using a center voltage value within a range capable of controlling the control voltage of the voltage-controlled oscillator 15.
In accordance with the present circuit, it is possible to provide an advantage that the correction operation can be performed without connecting a special circuit during the correction.

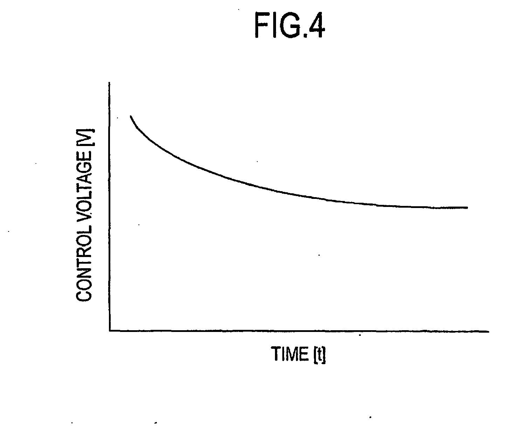

### [Voltage Characteristics with Aging: Fig. 4]

Next, an example of optimum control voltage characteristics with aging in the present circuit is shown in Fig. 4. Fig. 4 is a view showing aging and control voltage characteristics.
As shown in Fig. 4, in the present circuit, the optimum control voltage decreases with the elapse of time (however, this corresponds to a case where the frequency deviation is rising).

### [Another Embodiment 2]

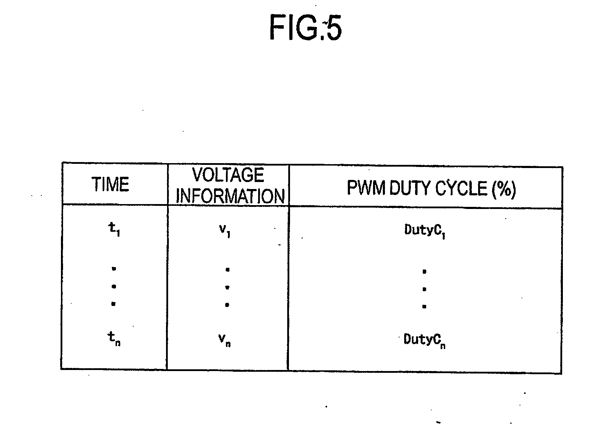

In a still further embodiment (another embodiment 2), the present circuit is configured to cope with the aging. Another embodiment 2 will be described with reference to Fig. 5. Fig. 5 is a schematic view of an aging characteristics table.
Although the memory 21 stores therein the voltage and PWM duty cycle table, the present circuit uses the aging characteristics table shown in Fig. 5 in lieu of the voltage and PWM duty cycle.

The aging characteristics table of Fig. 5 incorporates a time factor into the relationship between the voltage information and the PWM duty cycle.
Specifically, a voltage information which is appropriately set for a given elapse time and a PWM duty cycle corresponding to the voltage information are stored as a table.
The CPU 20 measures an elapse time by means of a timer provided therein.

In another embodiment 2, when the detection level of the external reference signal is outside the appropriate range, the CPU 20 turns off the switch 13, refers to the time measured by the internal timer to retrieve the PWM duty cycle from the voltage information corresponding to the time, and outputs a pulse generation information corresponding to the PWM duty cycle to the PWM circuit 22. Then, the PWM circuit 22 generates desired pulses and outputs the control voltage to the voltage-controlled oscillator 15 via the loop filter 14.

In this manner, in another embodiment 2, upon occurrence of an abnormality of the external reference signal, the CPU 20 corrects the oscillation frequency using the pulses generated in accordance with the voltage information corresponding to the aging and the PWM duty cycle corresponding to the voltage information. Therefore, it is possible to provide an advantage that the frequency control circuit can cope with the aging.

Moreover, in the circuit configuration of another embodiment 2, a correction operation may be performed.
In this case, the CPU 20 measures an elapse time, and during the correction, performs frequency control by using a voltage value corresponding to the elapse time by referring to the aging characteristics table. Therefore, it is possible to provide an advantage that the correction operation can cope with the aging of the frequency control circuit.

### Industrial Applicability

The present invention is suitable for an oscillation frequency control circuit capable of correcting its own frequency and maintaining a stable oscillation frequency even when a highly stable reference signal is not input thereto and it operates is in a free-running state.

## Claims

1. An oscillation frequency control circuit comprising: '
a voltage-controlled oscillator (15);
a frequency divider configured to divide an output from the voltage-controlled oscillator (15);
a phase comparator (12) configured to compare phases of an external reference signal and an output from the frequency divider (16);
a loop filter (14) configured to smooth out an output from the phase comparator (12) and output a control voltage to the voltage-controlled oscillator (15);
a detection circuit (17) capable of detecting the external reference signal;
a pulse generation circuit (22) configured to generate pulses upon receipt of a pulse generation information to be output to the loop filter (14);
a memory (21) capable of storing therein control voltage information and pulse generation information corresponding to the control voltage information wherein a value of the control voltage output to the voltage-controlled oscillator (15) is used as the control voltage information;
a switch (13) configured to turn on/off a connection between the phase comparator (12) and the loop filter (14); and
a control unit (20) configured to turn on the switch (13) when a level of the external reference signal detected by the detection circuit (17) is within an appropriate range while turning off the switch (13) when the level is outside the appropriate range to thereby output the pulse generation information stored in the memory (21) to the pulse generation circuit (22),
wherein the pulse generation circuit is a pulse width modulation circuit (22), and the pulse generation information output from the control unit (20) is information on a pulse width modulation duty cycle, **characterized in that**
the memory (21) stores an aging characteristics table comprising the control voltage information which corresponds to a measured time the pulse generation information corresponding to the control voltage information, and
the control unit (20) measures a measured time by means of a timer provided therein, retrieves the control voltage information corresponding to the measured time from the aging characteristics table of the memory (21) when the level of the external reference signal is outside the appropriate range, reads out the pulse generation information corresponding to the retrieved control voltage information, and outputs the read pulse generation information to the pulse generation circuit (22).

2. An oscillation frequency control circuit comprising:
a voltage-controlled oscillator (15);
a frequency divider configured to divide an output from the voltage-controlled oscillator (15);
a phase comparator (12) configured to compare phases of an external reference signal and an output from the frequency divider (16);
a loop filter (14) configured to smooth out an output from the phase comparator (12) and output a control voltage to the voltage-controlled oscillator (15);
a detection circuit (17) capable of detecting the external reference signal;
a pulse generation circuit (22) configured to generate pulses upon receipt of a pulse generation information to be output to the loop filter (14);
a memory (21) capable of storing therein control voltage information and pulse generation information corresponding to the control voltage information wherein a value of the control voltage output to the voltage-controlled oscillator (15) is used as the control voltage information;
a switch (13) configured to turn on/off a connection between the phase comparator (12) and the loop filter (14); and
a control unit (20) configured to turn on the switch (13) when a level of the external reference signal detected by the detection circuit (17) is within an appropriate range while turning off the switch (13) when the level is outside the appropriate range to thereby output the pulse generation information stored in the memory (21) to the pulse generation circuit (22).
wherein the pulse generation circuit (22) is a pulse width modulation circuit, and the pulse generation information output from the control unit (20) is information on a pulse width modulation duty cycle, **characterized in that**
a level detection circuit (23) configured to detect a voltage level of an output from the loop filter (14) to thereby output a latest control voltage information to the control unit is provided,
the memory (21) stores a voltage/pulse generation information table, the table storing the latest control voltage information, a plurality of control voltage information, and the pulse generation information corresponding to the control voltage information, and
the control unit (20) updates the latest control voltage information of the memory (21) to the latest control voltage information output from the level detection circuit (23), reads out the pulse generation information corresponding to the latest control voltage information from the voltage/pulse generation information table of the memory (21) when the level of the external reference signal is within the appropriate range, and outputs the read pulse generation information to the pulse generation circuit (22).

3. The oscillation frequency control circuit according to claim 1 or claim 2, wherein a voltage controlled crystal oscillator, a voltage controlled-temperature compensated crystal oscillator, or a voltage controlled, oven controlled crystal oscillator is used as the voltage-controlled oscillator (15).

4. The oscillation frequency control circuit according to claim 1, wherein when the detection circuit (17) detects that the external reference signal is not present, the control unit (20) turns off the switch (13) and outputs the pulse generation information stored in the memory (21) to the pulse generation circuit (22), thereby controlling the voltage-controlled osillator (15) in accordance with the control voltage information corresponding to the measured time.

## Patentansprüche

1. Schwingungsfrequenz-Steuerschaltkreis, mit folgenden Merkmalen:
ein spannungsgesteuerter Oszillator (15);
ein Frequenzteiler, der dazu konfiguriert ist, ein Ausgangssignal von dem spannungsgesteuerten Oszillator (15) zu teilen;
ein Phasenkomparator (12), der dazu konfiguriert ist, Phasen eines externen Referenzsignals und eines Ausgangssignals des Frequenzteilers (16) zu vergleichen;
ein Schleifenfilter (14), das dazu konfiguriert ist, ein Ausgangssignal von dem Phasenkomparator (12) zu glätten und eine Steuerspannung an den spannungsgesteuerten Oszillator (15) auszugeben;
ein Erfassungsschaltkreis (17), der das externe Referenzsignal erfassen kann;
ein Impulserzeugungsschaltkreis (22), der dazu konfiguriert ist, bei Empfang von Impulserzeugungsinformation Impulse zu erzeugen, die an das Schleifenfilter (14) auszugeben sind;
ein Speicher (21), der Steuerspannungsinformation und Impulserzeugungsinformation, die der Steuerspannungsinformation entspricht, speichern kann, wobei ein Wert der an den spannungsgesteuerten Oszillator (15) ausgegebenen Steuerspannung als die Steuerspannungsinformation genutzt wird;
ein Schalter (13), der dazu konfiguriert ist, eine Verbindung zwischen dem Phasenkomparator (12) und dem Schleifenfilter (14) ein- und auszuschalten; und
eine Steuereinheit (20), die dazu konfiguriert ist, den Schalter (13) einzuschalten, wenn ein Niveau des von dem Erfassungsschaltkreis (17) erfassten externen Referenzsignals innerhalb eines geeigneten Bereichs liegt, und den Schalter (13) auszuschalten, wenn das Niveau außerhalb des geeigneten Bereichs liegt, um dadurch die in dem Speicher (21) gespeicherte Impulserzeugungsinformation an den Impulserzeugungsschaltkreis (22) auszugeben,
wobei der Impulserzeugungsschaltkreis ein Puls-Breiten-Modulations-Schaltkreis (22) ist und die von der Steuereinheit (20) ausgegebene Impulserzeugungsinformation Information über ein Impuls-Breiten-Modulations-Tastverhältnis ist, **dadurch gekennzeichnet, dass**
der Speicher (21) eine Alterungskenndatentabelle speichert, welche die Steuerspannungsinformation, die einer gemessenen Zeit entspricht, und die Impulserzeugungsinformation, die der Steuerspannungsinformation entspricht, umfasst, und
die Steuereinheit (20) eine gemessene Zeit mit Hilfe eines darin vorgesehenen Zeitgebers misst, die der gemessenen Zeit entsprechende Steuerspannungsinformation aus der Alterungskenndatentabelle des Speichers (21) abruft, wenn das Niveau des externen Referenzsignals außerhalb des geeigneten Bereichs liegt, die der abgerufenen Steuerspannungsinformation entsprechende Impulserzeugungsinformation ausliest und die gelesene Impulserzeugungsinformation an den Impulserzeugungsschaltkreis (22) ausgibt.

2. Schwingungsfrequenz-Steuerschaltkreis, mit folgenden Merkmalen:
ein spannungsgesteuerter Oszillator (15);
ein Frequenzteiler, der dazu konfiguriert ist, ein Ausgangssignal von dem spannungsgesteuerten Oszillator (15) zu teilen;
ein Phasenkomparator (12), der dazu konfiguriert ist, Phasen eines externen Referenzsignals und eines Ausgangssignals des Frequenzteilers (16) zu vergleichen;
ein Schleifenfilter (14), das dazu konfiguriert ist, ein Ausgangssignal von dem Phasenkomparator (12) zu glätten und eine Steuerspannung an den spannungsgesteuerten Oszillator (15) auszugeben;
ein Erfassungsschaltkreis (17), der das externe Referenzsignal erfassen kann;
ein Impulserzeugungsschaltkreis (22), der dazu konfiguriert ist, bei Empfang einer Impulserzeugungsinformation Impulse zu erzeugen, die an das Schleifenfilter (14) auszugeben sind;
ein Speicher (21), der Steuerspannungsimformation und Impulserzeugungsinformation, die der Steuerspannungsinformation entspricht, speichern kann, wobei ein Wert der an den spannungsgesteuerten Oszillator (15) ausgegebenen Steuerspannung als die Steuerspannungsinformation genutzt wird;
ein Schalter (13), der dazu konfiguriert ist, eine Verbindung zwischen dem Phasenkomparator (12) und dem Schleifenfilter (14) ein- und auszuschalten; und
eine Steuereinheit (20), die dazu konfiguriert ist, den Schalter (13) einzuschalten, wenn ein Niveau des von dem Erfassungsschaltkreis (17) erfassten externen Referenzsignals innerhalb eines geeigneten Bereichs liegt, und den Schalter (13) auszuschalten, wenn das Niveau außerhalb des geeigneten Bereichs liegt, um dadurch die in dem Speicher (21) gespeicherte Impulserzeugungsinformation an den Impulserzeugungsschaltkreis (22) auszugeben,
wobei der Impulserzeugungsschaltkreis (22) ein Puls-Breiten-Modulations-Schaltkreis (22) ist und die von der Steuereinheit (20) ausgegebene Impulserzeugungsinformation Information über ein Impuls-Breiten-Modulations-Tastverhältnis ist, **dadurch gekennzeichnet, dass**
ein Niveauerfassungsschaltkreis (23) vorgesehen ist, der dazu konfiguriert ist, ein Spannungsniveau eines Ausgangssignals des Schleifenfilters (14) zu erfassen, um dadurch eine letzte Steuerspannungsinformation an die Steuereinheit auszugeben,
der Speicher (21) eine Spannungs/Impuls-Erzeugungsinformations-Tabelle speichert, wobei die Tabelle die letzte Steuerspannungsinformation, eine Vielzahl von Steuerspannungsinformationen und die der Steuerspannungsinformation entsprechende Impulserzeugungsinformation speichert, und
die Steuereinheit (20) die letzte Steuerspannungsinformation des Speichers (21) auf die von dem Niveauerfassungsschaltkreis (23) ausgegebene letzte Steuerspannungsinformation aktualisiert, die der letzten Steuerspannungsinformation entsprechende Impulserzeugungsinformation aus der Spannungs/Impuls-Erzeugungsinformations-Tabelle des Speichers (21) ausliest, wenn das Niveau des externen Referenzsignals innerhalb des geeigneten Bereichs liegt, und die gelesene Impulserzeugungsinformation an den Impulserzeugungsschaltkreis (22) ausgibt.

3. Schwingungsfrequenz-Steuerschaltkreis nach Anspruch 1 oder Anspruch 2, wobei ein spannungsgesteuerter Quarzoszillator, ein spannungsgesteuerter temperaturkompensierter Quarzoszillator oder ein spannungsgesteuerter temperaturstabilisierter Quarzoszillator als der spannungsgesteuerte Oszillator (15) verwendet wird.

4. Schwingungsfrequenz-Steuerschaltkreis nach Anspruch 1, wobei dann, wenn der Erfassungsschaltkreis (17) erfasst, dass das externe Referenzsignal nicht vorliegt, die Steuereinheit (20) den Schalter (13) ausschaltet und die in dem Speicher (21) gespeicherte Impulserzeugungsinformation an den Impulserzeugungsschaltkreis (22) ausgibt und dadurch den spannungsgesteuerten Oszillator (15) gemäß der Steuerspannungsinformation, die der gemessenen Zeit entspricht, steuert.

## Revendications

1. Circuit de commande de fréquence d'oscillation comprenant :
un oscillateur à commande en tension (15) ;
un diviseur de fréquence agencé pour diviser la sortie de l'oscillateur à commande en tension (15) ;
un comparateur de phase (12) agencé pour comparer les phases d'un signal de référence externe et d'une sortie du diviseur de fréquence (16) ;
un filtre de boucle (14) agencé pour lisser une sortie du comparateur de phase (12) et fournir une tension de commande à l'oscillateur à commande en tension (15) ;
un circuit de détection (17) apte à détecter le signal de référence externe ;
un circuit de génération d'impulsions (22) agencé pour produire des impulsions après réception d'une information de génération d'impulsions à fournir au filtre de boucle (14) ;
une mémoire (21) apte à mémoriser une information de tension de commande et une information de génération d'impulsions correspondant à l'information de tension de commande, la valeur de la sortie de tension de commande vers l'oscillateur à commande en tension (15) étant utilisée en tant qu'information de tension de commande ;
un commutateur (13) agencé pour commuter à la fermeture et à l'ouverture une connexion entre le comparateur de phase (12) et le filtre de boucle (14) ; et
un module de commande (20) agencé pour rendre passant le commutateur (13) quand le niveau du signal de référence externe détecté par le circuit de détection (17) est à l'intérieur d'une plage appropriée et pour commuter à l'ouverture le commutateur (13) quand le niveau est à l'extérieur de la plage appropriée pour fournir ainsi l'information de génération d'impulsions mémorisée dans la mémoire (21) vers le circuit de génération d'impulsions (22),
dans lequel le circuit de génération d'impulsions est un circuit à modulation de largeur d'impulsions (22) et la sortie d'information de génération d'impulsions à partir du module de commande (20) est une information sur le rapport cyclique de modulation de la largeur d'impulsions,
**caractérisé en ce que** :
la mémoire (21) mémorise une table caractéristique de vieillissement comprenant l'information de tension de commande qui correspond à une durée mesurée et l'information de génération d'impulsions qui correspond à l'information de tension de commande, et
le module de commande (20) mesure une durée mesurée au moyen d'un minuteur qui y est prévu, récupère l'information de tension de commande correspondant à la durée mesurée à partir de la table caractéristique de vieillissement de la mémoire (21) quand le niveau du signal de référence externe est en dehors de la plage appropriée, lit l'information de génération d'impulsions correspondant à l'information de tension de commande récupérée, et fournit l'information de génération d'impulsions de lecture au circuit de génération d'impulsions (22).

2. Circuit de commande de fréquence d'oscillation comprenant :
un oscillateur à commande en tension (15) ;
un diviseur de fréquence agencé pour diviser la sortie de l'oscillateur à commande en tension (15) ;
un comparateur de phase (12) agencé pour comparer les phases d'un signal de référence externe et d'une sortie du diviseur de fréquence (16) ;
un filtre de boucle (14) agencé pour lisser une sortie du comparateur de phase (12) et fournir une tension de commande à l'oscillateur à commande en tension (15) ;
un circuit de détection (17) apte à détecter le signal de référence externe ;
un circuit de génération d'impulsions (22) agencé pour produire des impulsions après réception d'une information de génération d'impulsions à fournir au filtre de boucle (14) ;
une mémoire (21) apte à mémoriser une information de tension de commande et une information de génération d'impulsions correspondant à l'information de tension de commande, la valeur de la sortie de tension de commande vers l'oscillateur à commande en tension (15) étant utilisée en tant qu'information de tension de commande ;
un commutateur (13) agencé pour commuter à la fermeture et à l'ouverture une connexion entre le comparateur de phase (12) et le filtre de boucle (14) ; et
un module de commande (20) agencé pour rendre passant le commutateur (13) quand le niveau du signal de référence externe détecté par le circuit de détection (17) est à l'intérieur d'une plage appropriée et pour commuter à l'ouverture le commutateur (13) quand le niveau est à l'extérieur de la plage appropriée pour fournir ainsi l'information de génération d'impulsions mémorisée dans la mémoire (21) vers le circuit de génération d'impulsions (22),
dans lequel le circuit de génération d'impulsions est un circuit à modulation de largeur d'impulsions (22) et la sortie d'information de génération d'impulsions à partir du module de commande (20) est une information sur le rapport cyclique de modulation de la largeur d'impulsions,
**caractérisé en ce que** :
un circuit de détection de niveau (23) agencé pour détecter le niveau de tension d'une sortie du filtre de boucle (14) pour fournir ainsi une dernière information de tension de commande au module de commande est prévu ;
la mémoire (21) mémorise une table d'informations de génération de tension/impulsions, la table mémorisant la dernière information de tension de commande, une pluralité d'informations de tension de commande, et l'information de génération d'impulsions correspondant à l'information de tension de commande, et
le module de commande (20) fournit la dernière information de tension de commande de la mémoire (21) à la sortie de la dernière information de tension de commande en provenance du circuit de détection de niveau (23), lit l'information de génération d'impulsions correspondant à la dernière information de tension de commande en provenance de la table d'informations de génération de tension/impulsions de la mémoire (21) quand le niveau du signal de référence externe est dans la plage appropriée et fournit l'information de génération d'impulsions de lecture au circuit de génération d'impulsions (22).

3. Circuit de commande de fréquence d'oscillation selon la revendication 1 ou 2, dans lequel un oscillateur à quartz commandé, un oscillateur à quartz compensé en température et commandé en tension, ou un oscillateur à quartz régulé en température et commandé en tension est utilisé en tant qu'oscillateur à commande en tension (15).

4. Circuit de commande de fréquence d'oscillation selon la revendication 1, dans lequel, quand le circuit de détection (17) détecte que le signal de référence externe n'est pas présent, le module de commande (20) coupe le commutateur (13) et fournit l'information de génération d'impulsions mémorisée dans la mémoire (21) au circuit de génération d'impulsions (22), commandant ainsi l'oscillateur à commande en tension (15) en accord avec l'information de tension de commande correspondant à la durée mesurée.
